# EUROPEAN PATENT APPLICATION

(11) **EP 1 887 628 A1**
(43) Date of publication of application: **13.02.2008**
(21) Application number: 06076451.1
(22) Date of filing: 20.07.2006
(51) Int. Cl.: H01L 27/32, H01L 51/52, H01L 51/44

(54) **Electro-optical device**

(71) Applicant: Nederlandse Organisatie voor toegepast-natuurwetenschappelijk Onderzoek TNO, 2628 VK Delft (NL)
(72) Inventor: The designation of the inventor has not yet been filed
(74) Representative: van Loon, C.J.J.

(57) **Abstract**

Electro-optical device, comprising a first, transparent electrode layer (1), an electro-optical layer (2a,b) and a second electrode layer (3). The electro-optical layer consists in a plurality of small sized electro-optical areas captured between a protruding structure (5,6). The structure in this electro-optical device comprises a conductive layer (5) upon said transparent electrode layer, causing less electrical loss in the transparent electrode layer and thus increasing the EO configuration's power. Additionally, the structure upon the transparent electrode layer enables compartimentation of the "wide area" EO configuration, facilitating an accurate even distribution of the EO layers over the surface. Preferably the structure (5,6) comprises a nonconductive layer (6) to prevent short-circuit. The structure (5,6) may be built up by means of 3D-printing.

## Description

### Field

The invention concerns an electro-optical device, comprising at least a first, transparent electrode layer, an electro-optical, e.g. light emitting or photovoltaic layer and a second electrode layer, said electro-optical layer consisting in a plurality of small sized electro-optical areas captured between a protruding structure.

### Background

Electro-optical devices like e.g. light-emitting diodes (LEDs) may comprise a multilayer configuration which may comprise a metal counter electrode, an electro-optical layer, preferably a conductive polymer (e.g. PEDOT, PPS), a conductive transparent conductive metal oxide layer (e.g. ITO) and a carrier layer. For the manufacturing of e.g. "wide area LEDs" compartimentation of the substrate may be used for the preparation of (patterned) layers of homogeneous thickness, as is known from e.g. US2005/0190253. By applying a grid structure, e.g. made by means of embossing, extrusion, calendaring etc. and subsequently filling the grid compartments by means of "ink-jet" techniques sufficient control of the film thickness can be realized.

So from the prior art an electro-optical (viz. light emitting) device is known, comprising a first, transparent electrode layer, an electro-optical layer and a second electrode layer, said electro-optical layer consisting in a plurality of small sized electro-optical areas captured between a protruding structure.

It is noted that where, in the foregoing and the following, is spoken of light emitting (E/O) layers etc., photo-voltaic (O/E) layers etc. tacitly will be included. In other words, the invention includes all kinds of EO converters, both E->0 converters, needing an electrical input and producing an optical (light) output, like LEDs etc., and O->E converters like photovoltaic devices, needing an optical (light) input and producing an electrical (current, voltage) output.

### Summary of the invention

One aspect of the present invention is to provide advanced "wide area" EO configurations, i.e. EO configurations having rather large luminous surfaces. Another aspect of the invention is to provide EO configurations for a more powerful EO conversion.

According to the invention, in an electro-optical device as introduced in the preamble, the protruding structure of the intermediate electro-optical layer comprises a conductive layer upon said transparent electrode layer.

Hence, the present invention provides an electro-optical device, comprising a first, transparent electrode layer (1), an electro-optical layer (2a,b) and a second electrode layer (3), said electro-optical layer consisting in a plurality of small sized electro-optical areas captured between a protruding structure (5,6), characterized in that said structure comprises a conductive layer (5) upon said transparent electrode layer.

Preferably, the protruding structure (5,6) protrudes towards the second electrode layer (3).

Preferably, the protruding structure (5,6) comprises a nonconductive layer (6) upon the conductive layer (5) of said structure.

Preferably, said structure (5, 6) is built up by means of three-dimensional printing.

The conductive structure upon (and connected with) the transparent electrode layer reduces the electrical resistance of the transparent electrode layer together with the conductive structure applied upon it. Due to that the entire EO configuration will be fit to convert a larger electrical current (less electrical loss) into light and/or vice versa, thus increasing the EO configuration's power.

Additionally, the structure upon the transparent electrode layer serves for compartimentation of the "wide area" EO configuration, facilitating the required even distribution of the EO layers over the surface. Besides, the structure provides a mechanical reinforcement of the EO configuration. Both effects, however, are known as such from US2005/0190253.

It is preferred that the structure (5, 6) protrudes towards said second electrode layer. However, in an alternative embodiment of the present invention, the protruding structure (5, 6) may be turned away from the second electrode layer, i.e. may be at the opposing side of the transparent electrode layer.

Preferably, the protruding structure (5, 6) comprises a nonconductive layer upon the conductive layer of said structure. The nonconductive layer forms an insulating layer between the protruding conductive layer and the second electrode layer, safeguarding against short-circuit. Moreover, the effect of the nonconductive layer upon the conductive layer of said structure is an additional mechanical strengthening of the whole EO configuration.

Concerning the manufacturing, the structure may be built up by means of three-dimensional (3D) printing, like inkjet printing, in which the relevant structure material - in liquid form - is fed into a jet head that deposits tiny droplets, forming a layer of the structure. The droplets may be cured by exposing to UV light.

Preferably, the structure (5, 6) has the shape of a grid. The exact shape of the grid is not important as long as the surface within compartments formed by the grid is equal all over the device. A possible shape could be a honeycomb. An important function of the grid is to increase the conductivity of the substrate sufficiently to enable exact electrical control over the full surface of the "mega pixel".

According to one aspect of the invention, the grid is at least partially made of a conductive material (e.g. a metal), which will lead to better surface conductivity of the transparent (ITO) electrode. Most probably, a support electrode in the form of bus bars or bus lines would have been necessary anyway to arrive at a sufficiently high conductivity of the ITO surface for the application in large area systems. Therefore, the proposed grid will exhibit a combined functionality: it will serve as a support electrode for the metal oxide electrode and it will supply the compartimentation, facilitating even distribution of the EO layers over the surface.

### Exemplary Embodiment

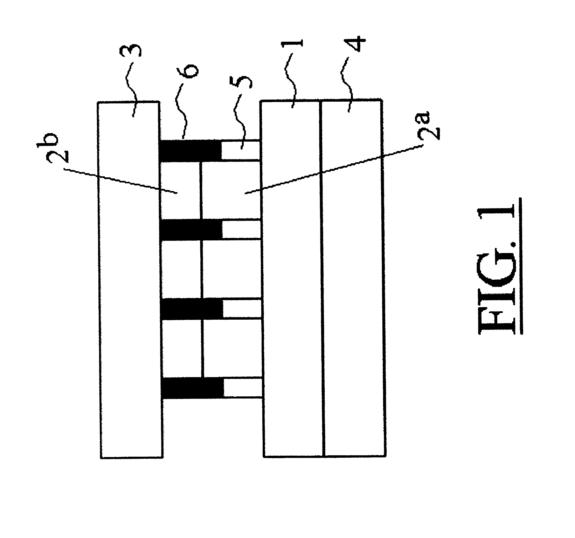

Figure 1 shows schematically an embodiment of an electro-optical device according to the present invention.

The electro-optical device shown in figure 1 comprises a first, transparent electrode layer 1 (e.g. made of ITO), an electro-optical layer 2, comprising a sub-layer 2a of a polymeric semiconductor (e.g. made of PEDOT) and a sub-layer 2b of an electro-optical polymer, and a second electrode layer 3. The transparent electrode layer 1 may be supported by a transparent carrier layer 4. The electro-optical layer 2 consists in a plurality of small sized electro-optical areas ("pixels") which are captured between a protruding structure. Said structure comprises a conductive layer 5 which is applied upon the transparent electrode layer 1. The (e.g. grid shaped) structure 5 protrudes towards the second electrode layer 3. Upon the conductive layer 5 of the protruding structure a nonconductive (isolating) structure layer 6 is applied. Both structures may be built up by means of a three-dimensional printing process.

The conductive structure layer may be made of e.g. Aluminum and the non-conducting structure layer of Aluminum oxide, e.g. be means of 3-D printing both structure layers complete of Aluminum and oxidizing the upper layer of it, thus forming a (non-conducting) Al₂O₃ layer.

## Claims

1. Electro-optical device, comprising a first, transparent electrode layer (1), an electro-optical layer (2a,b) and a second electrode layer (3), said electro-optical layer consisting in a plurality of small sized electro-optical areas captured between a protruding structure (5,6), **characterized in that** said structure comprises a conductive layer (5) upon said transparent electrode layer.

2. Device according to claim 1, wherein the structure (5,6) protrudes towards said second electrode layer (3).

3. Device according to claim 2, wherein the structure (5,6) comprises a nonconductive layer (6) upon the conductive layer (5) of said structure.

4. Device according to any one of claims 1-3, wherein said structure is built up by means of three-dimensional printing.
